# EUROPEAN PATENT SPECIFICATION

(11) **EP 0 643 404 B1**
(45) Date of publication and mention of the grant of the patent: **14.05.1997**
(21) Application number: 94116854.4
(22) Date of filing: 17.08.1990
(51) Int. Cl.: H01F 17/00, H01F 27/28

(54) **Inductive structures for semiconductor integrated circuits**
Induktive Strukturen für halbleitende integrierte Schaltungen
Structures inductives pour circuits intégrés semi-conducteurs

(30) Priority: 18.08.1989 JP 213839/89
(43) Date of publication of application: 15.03.1995
(62) Divisional of application: 90115799.0
(73) Proprietor: MITSUBISHI DENKI KABUSHIKI KAISHA, Tokyo (JP)
(72) Inventor: Andoh, Naoto, Mitsubishi Denki K.K., 4-chome, Itami-shi, Hyogo-ken (JP); Inoue, Akira, Mitsubishi Denki K.K., 4-chome, Itami-shi, Hyogo-ken (JP); Nakajima, Yasuharu, Mitsubishi Denki K.K., 4-chome, Itami-shi, Hyogo-ken (JP); Nakahara, Kazuhito, Mitsubishi Denki K.K., 4-chome, Itami-shi, Hyogo-ken (JP)
(74) Representative: TER MEER STEINMEISTER & PARTNER GbR

(56) References cited:
- WO-A-87/01505
- WO-A-87/07074
- GB-A- 2 173 956
- PATENT ABSTRACTS OF JAPAN vol. 8 no. 231 (E-274) ,24 October 1984 & JP-A-59 114807 (MATSUSHITA) 3 July 1984,

## Description

The invention relates to a variable inductance element as claimed in the preamble of claim 1.

Such kind of element is already known from WO-A-87 07074 comprising: an electrically insulating substrate having opposed first and second surfaces; an electrical conductor disposed in a first spiral on the first surface of the substrate; an electrically insulating film disposed on the first surface and the first spiral; a second electrical conductor disposed in a second spiral on the electrically insulating film and inductively coupled to the first spiral; and means for producing and controlling an electrical current flow through one of said spirals.

It is an object of the present invention to provide another inductive structure having a controllable variable inductance.

A solution of this object is characterized by: an electrically conducting first via penetrating the electrically insulating film electrically connecting a first end of the first spiral to a first end of the second spiral; and an electrically conducting ground plane disposed on the second surface of the substrate and a second electrically conducting via passing through the substrate from the first to the second surface electrically connecting a second end of the first spiral to the ground plane.

The invention will be described in the following in more detail while referring to the enclosed Figures, in which:
Figure 1(a) is a perspective view of a variable inductance according to an embodiment of the invention; Figure 1(b) is a schematic diagram of an equivalent circuit of the variable inductance of Figure 1(a); and
Figure 2 is a schematic circuit diagram of a modification of the variable inductance of Figure 1(a).

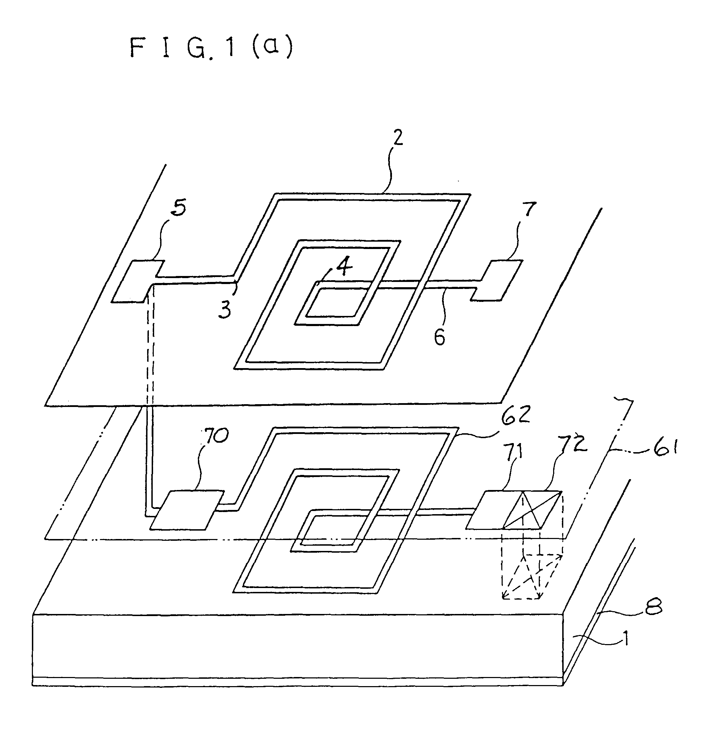

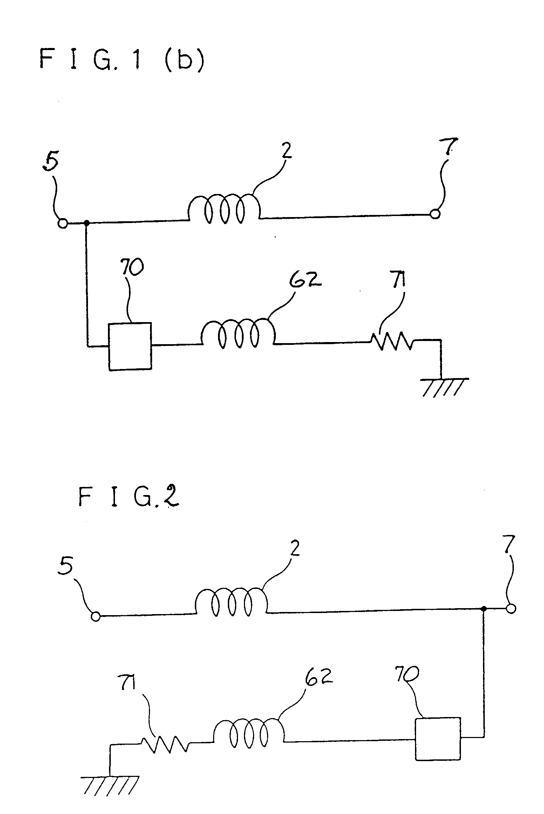

In Figure 1(a), a perspective view of a variable inductance according to the invention is shown. The variable inductance includes two similar spiral inductive structures. A spiral 2 includes an electrical conductor disposed on an electrically insulating substrate and a lead 6 in an air bridge structure connecting the internal end 4 of the spiral 2 to a terminal 7. The external end 3 of the spiral 2 is directly connected to a terminal 5. A similar spiral 62 is disposed on a substrate 1. The two spirals 2 and 62 are separated by an electrically insulating film 61. The terminals of spiral 62 are connected to an electrical signal source that causes a current to flow through spiral 62. The phase and magnitude of that current flow varies the effective inductance of spiral 2 because of the mutual inductive coupling of the two spirals. An electrically conducting ground plane 8 is disposed on the surface of substrate 1 opposite that on which spiral 62 is disposed.

A current I₁ flows through spiral 2 and a current I₂ flows through spiral 62 because of the signal applied by signal source. The inductances of spirals 2 and 62 are L₁ and L₂, respectively, and voltages V₁ and V₂ appear across those coils. If the impedance of the signal source is Z₀ and the mutual inductance between the spirals is M, then${\text{V}}_{\text{1}} {\text{= jωL}}_{\text{1}} {\text{I}}_{\text{1}} {\text{+ jωMI}}_{\text{2}}$${\text{V}}_{\text{2}} {\text{= jωL}}_{\text{2}} {\text{I}}_{\text{2}} {\text{+ jωMI}}_{\text{1}}$${\text{V}}_{\text{2}} {\text{= -Z}}_{\text{0}} {\text{I}}_{\text{2}} \text{.}$

The effective impedance Z₁ of spiral 2 is thus${\text{Z}}_{\text{1}} {\text{= V}}_{\text{1}} {\text{/I}}_{\text{1}} {\text{= jωL}}_{\text{1}} {\text{+ jω(I}}_{\text{2}} {\text{/I}}_{\text{1}} {\text{)}}^{\text{2}} {\text{(Z}}_{\text{0}} {\text{- jωL}}_{\text{2}} \text{)} {\text{= ω}}^{\text{2}} {\text{(I}}_{\text{2}} {\text{/I}}_{\text{1}} {\text{)}}^{\text{2}} {\text{L}}_{\text{2}} {\text{+ jω[L}}_{\text{1}} {\text{+ (I}}_{\text{2}} {\text{/I}}_{\text{1}} {\text{)}}^{\text{2}} {\text{Z}}_{\text{0}} \text{].}$

From these equations, it follows that:${\text{jωM = (Z}}_{\text{0}} {\text{- jωL}}_{\text{2}} {\text{) (I}}_{\text{2}} {\text{/I}}_{\text{1}} \text{).}$

Since the inductances of the spirals L₁ and L₂ and the impedance of the signal source Z₀ are constant, it is apparent from the equations that the effective impedance of the spiral 2, Z₁, is a function of the currents I₁ and I₂ and can be varied by controlling I₂. The effective impedance of spiral 2 can also be increased or decreased depending upon the relative phases of the currents I₁ and I₂.

In Figure 1(a), terminal 5 of spiral 2 is connected through a via to the external end of spiral 62. A circuit 70 is connected in series with spiral 62 for varying the current flowing through spiral 62. Circuit 70 may be both an attenuator and an amplifier for decreasing and increasing the current flow through spiral 62. The other end of spiral 62 is connected through a termination 71 to the ground plane 8 by means of a via 72. An equivalent circuit of the structure of Figure 1(a) is shown in Figure 1(b). The current flowing in spiral 62 is controlled by circuit 70, thereby altering the effective inductance of spiral 2 in accordance with the equations set forth above. In particular, circuit 70 permits control of the ratio of current flows I₂/I₁, varying the impedance Z₁ of spiral 2. Depending upon the relative phases of the currents flowing through spirals 2 and 62, the effective inductance of spiral 2 can be increased or decreased.

The connections of spiral 62 may be reversed as shown in the equivalent circuit of Figure 2. In the embodiment shown in Figure 1(a), the spirals 2 and 62 are wound in the same direction. By winding one of the spirals 2 and 62 in the reverse direction from the other, the direction of change of the inductance of spiral 2 with current flowing in spiral 62 can be reversed as if the connections of spiral 62 were reversed, i.e., changed from those of Figure 1(b) to those of Figure 2. While the embodiment of the invention shown in Figure 1(a) employs two layer structures including two spirals, additional layers including additional spiral inductors can also be employed.

## Claims

1. A variable inductance element integrable with a semiconductor integrated circuit comprising:
an electrically insulating substrate (1) having opposed first and second surfaces;
an electrical conductor disposed in a first spiral (62) on the first surface of the substrate (1);
an electrically insulating film (61) disposed on the first surface and the first spiral (62);
a second electrical conductor disposed in a second spiral (2) on the electrically insulating film (61) and inductively coupled to the first spiral (62); and
means for producing and controlling an electrical current flow through one of said spirals,
**characterized by:**
an electrically conducting first via penetrating the electrically insulating film(61) electrically connecting a first end of the first sprial (62) to a first end of the second spiral (2); and
an electrically conducting ground plane (8) disposed on the second surface of the substrate (1) and a second electrically conducting via (72) passing through the substrate (1) from the first to the second surface elecrically connecting a second end of the first spiral (62) to the ground plane (8).

2. The variable inductance element of claim 1, **characterized in that** the substrate (1) is an electrically insulating semiconductor.

3. The variable inductance element of claim 2, **characterized in that** the substrate (1) is chosen from the group consisting of gallium arsenide and indium phosphide.

4. The variable inductance element as claimed in one of the claims 1 to 3, **characterized in that** the current producing means producing and controlling an electical current flow through the first spiral (62).

5. The variable inductance element of claim 1, **characterized in that** the means (70) for controlling a flow of current through the second spiral (2) is serially connected to the first end (5) of the second spiral (2) and an electrical termination (71) connected between the second end of the first spiral (62) and the ground plane (8).

6. The variable inductance element of claim 5, **characterized in that** the controlling means (70) is selected from the group consisting of an attenuator and an amplifier.

## Patentansprüche

1. Einstellbares Induktivitätselement, das in eine integrierte Halbleiterschaltung integrierbar ist, mit:
- einem elektrisch isolierenden Substrat (1) mit einer ersten und einer zweiten Fläche, die voneinander abgewandt sind;
- einem elektrischen Leiter, der als erste Spirale (62) auf der ersten Oberfläche des Substrats (1) angeordnet ist;
- einem elektrisch isolierenden Film (61), der auf der ersten Fläche und der ersten Spirale (62) angeordnet ist;
- einem zweiten elektrischen Leiter, der als zweite Spirale (2) auf dem elektrisch isolierenden Film (61) angeordnet ist und induktiv mit der ersten Spirale (62) gekoppelt ist; und
- einer Einrichtung zum Erzeugen und Einstellen eines elektrischen Stromflusses durch eine der Spiralen;
**gekennzeichnet durch:**
- jeweils einen ersten elektrisch leitenden Durchgang, der den elektrisch isolierenden Film (61) durchdringt und ein erstes Ende der ersten Spirale (62) elektrisch mit einem ersten Ende der zweiten Spirale (2) verbindet; und
- eine elektrisch leitende Masseebene (8), die auf der zweiten Fläche des Substrats (1) angeordnet ist, und eine zweite elektrisch leitende Durchführung (72), die von der ersten zur zweiten Fläche durch das Substrat (1) hindurchgeht und ein zweites Ende der ersten Spirale (62) elektrisch mit der Masseebene (8) verbindet.

2. Einstellbares Induktivitätselement nach Anspruch 1, **dadurch gekennzeichnet, dass** das Substrat (1) ein elektrisch isolierender Halbleiter ist.

3. Einstellbares Induktivitätselement nach Anspruch 2, **dadurch gekennzeichnet, dass** das Substrat (1) aus der aus Galliumarsenid und Indiumphosphid bestehenden Gruppe ausgewählt ist.

4. Einstellbares Induktivitätselement nach einem der Ansprüche 1 bis 3, **dadurch gekennzeichnet, dass** die Stromerzeugungseinrichtung einen elektrischen Stromfluss durch die erste Spirale (62) erzeugt und einstellt.

5. Einstellbares Induktivitätselement nach Anspruch 1, **dadurch gekennzeichnet, dass** die Einrichtung (70) zum Einstellen eines Stromflusses durch die zweite Spirale (2) in Reihe zum ersten Ende (5) der zweiten Spirale (2) geschaltet ist und ein elektrischer Abschluss (71) zwischen das zweite Ende der ersten Spirale (62) und die Masseebene (8) geschaltet ist.

6. Einstellbares Induktivitätselement nach Anspruch 5, **dadurch gekennzeichnet, dass** die Einstelleinrichtung (70) aus der aus einer Dämpfungseinrichtung und einem Verstärker bestehenden Gruppe ausgewählt ist.

## Revendications

1. Elément formant inductance variable pouvant être intégré avec un circuit intégré à semiconducteur comprenant :
un substrat électriquement isolant (1) ayant des première et seconde surfaces opposées ;
un conducteur électrique disposé dans une première spirale (62) sur la première surface du substrat (1) ;
un film électriquement isolant (61) disposé sur la première surface et la première spirale (62) ;
un second conducteur électrique disposé dans une seconde spirale (2) sur le film électriquement isolant (61) et couplé inductivement à la première spirale (62) ; et
un moyen pour produire et contrôler une circulation de courant électrique à travers l'une desdites spirales,
caractérisé par
chacune d'une première traversée électriquement conductrice pénétrant le film électriquement isolant (61) reliant électriquement une première extrémité de la première spirale (62) à une première extrémité de la seconde spirale (2) ; et
un plan de masse électriquement conducteur (8) disposé sur la seconde surface du substrat (1) et une seconde traversée électriquement conductrice (72) passant à travers le substrat (1) de la première à la seconde surface reliant électriquement une seconde extrémité de la première spirale (62) au plan de masse (8).

2. Elément d'inductance variable de la revendication 1, caractérisé en ce que le substrat (1) est un semiconducteur électriquement isolant.

3. Elément d'inductance variable de la revendication 2, caractérisé en ce que le substrat (1) est choisi dans le groupe consistant en arséniure de gallium et phosphure d'indium.

4. Elément d'inductance variable comme revendiqué dans l'une des revendications 1 à 3, caractérisé en ce que le moyen de production de courant produisant et contrôlant une circulation de courant électrique à travers la première spirale (62).

5. Elément d'inductance variable de la revendication 1, caractérisé en ce que le moyen (70) pour contrôler une circulation de courant à travers la seconde spirale (2) est relié en série à la première extrémité (5) de la seconde spirale (2) et une terminaison électrique (71) reliée entre la seconde extrémité de la première spirale (62) et le plan de masse (8).

6. Elément d'inductance variable de la revendication 5, caractérisé en ce que le moyen de contrôle (70) est choisi dans le groupe consistant en un atténuateur et un amplificateur.
